# EUROPÄISCHE PATENTSCHRIFT

(11) **EP 1 461 868 B1**
(45) Veröffentlichungstag und Bekanntmachung des Hinweises auf die Patenterteilung: **02.08.2006**
(21) Anmeldenummer: 02792687.2
(22) Anmeldetag: 23.12.2002
(51) Int. Cl.: H03M 11/00

(54) **EINGANGSSCHALTUNG UND VERFAHREN ZU DEREN BETRIEB**
INPUT CIRCUIT AND METHOD FOR THE OPERATION THEREOF
CIRCUIT D'ENTREE ET SON PROCEDE D'EXPLOITATION

(30) Priorität: 07.01.2002 DE 10200276
(43) Veröffentlichungstag der Anmeldung: 29.09.2004
(73) Patentinhaber: SIEMENS AKTIENGESELLSCHAFT, 80506 München (DE)
(72) Erfinder: GROSSER, Stefan, 92253 Schnaittenbach (DE); MAIER, Mario, 92266 Ensdorf (DE); MARK, Reinhard, 91217 Hersbruck (DE); SINGER, Monika, 92263 Ebermannsdorf (DE)
(86) Internationale Anmeldenummer: PCT/DE2002/004710
(87) Internationale Veröffentlichungsnummer: WO 2003/058822

(56) Entgegenhaltungen:
- EP-A- 0 556 549

## Beschreibung

Die Erfindung betrifft eine Eingangsschaltung gemäß dem Oberbegriff des Anspruchs 1 sowie ein Verfahren zu deren Betrieb gemäß dem Oberbegriff des Anspruchs 6.

Eine gattungsgemäße Eingangsschaltung bzw. ein entsprechendes Betriebsverfahren ist bekannt.

Die bekannte Eingangsschaltung weist einen Eingang, einen Spannungsteiler mit, einem Mittelabgriff, ein Verzögerungsglied, einen Steuerbaustein und Mittel zur Aufschaltung eines High- oder/und Low-Pegels auf. Dabei bildet ein erster Pol des Spannungsteilers den Eingang der Eingangsschaltung. Ein Signaleingang des Verzögerungsgliedes liegt am Mittelabgriff des Spannungsteilers und ein Ausgang des Verzögerungsgliedes ist mit dem Steuerbaustein verbunden. Die Mittel zur High- und Lowpegelaufschaltung werden durch den Steuerbaustein gesteuert und wirken auf den Signaleingang.

Das am Eingang der Eingangsschaltung anliegende Signal wird im Folgenden zur Unterscheidung als Prozesssignal bezeichnet. Es wird z. B. von einem Endschalter eines technischen Prozesses geliefert. Die Eingangsschaltung ist damit zum Aufnehmen digitaler oder analoger Signale aus einem z. B. durch ein Automatisierungsgerät, z. B. eine so genannte speicherprogrammierbare Steuerung, gesteuerten und/oder überwachten technischen Prozess vorgesehen. Die Eingangsschaltung kann dabei in eine so genannte Eingabebaugruppe integriert sein, die insbesondere in modularer Bauform mit einer so genannten Zentraleinheit einer speicherprogrammierbaren Steuerung kombinierbar ist.

Als Verzögerungsglied kommt bei der bekannten Eingangsschaltung ein RC-Glied zum Einsatz. Die Verzögerungszeit liegt mit der Dimensionierung der Widerstands-/Kondensatorkombination des RC-Gliedes fest. Zum Testen der Eingangsschaltung ist die High- und Lowpegelaufschaltung vorgesehen. Bei Aktivierung der Highpegelaufschaltung wird ein auf ein Bezugspotential bezogenes, definiertes High-Signal und bei Aktivierung der Lowpegelaufschaltung ein auf Massepotential bezogenes, definiertes Low-Signal an den Signaleingang gelegt.

Nachteilig bei dieser bekannten Eingangsschaltung bzw. dem entsprechenden Betriebsverfahren ist jedoch, dass die auch als Eingangsverzögerung bezeichnete Verzögerungszeit konstant ist.

Der Erfindung liegt daher die Aufgabe zugrunde, eine Eingangsschaltung sowie ein Verfahren zu deren Betrieb anzugeben, bei der/bei dem die Eingangsverzögerung des Verzögerungsgliedes während des Betriebs der Eingangsschaltung verändert werden kann.

Bezüglich der Eingangsschaltung wird die genannte Aufgabe erfindungsgemäß gelöst durch die Merkmale des Anspruchs 1. Dazu ist der Steuerbaustein mit dem Verzögerungsglied über eine Taktleitung verbunden, wobei die Verzögerungszeit des Verzögerungsgliedes mittels eines über die Taktleitung übermittelbaren Taktsignals beeinflussbar ist. Der Vorteil der Erfindung besteht darin, dass mit variabler Verzögerungszeit das Verhalten der Eingangsschaltung an wechselnde Bedürfnisse angepasst werden kann.

Vorteilhafte Ausgestaltungen der Eingangsschaltung sind Gegenstand der auf Anspruch 1 rückbezogenen Unteransprüche.

Bezüglich des Verfahrens zum Betrieb der Eingangsschaltung wird die Aufgabe erfindungsgemäß gelöst durch die Merkmale des Anspruchs 6. Dazu ist vorgesehen, dass über eine Taktleitung, die den Steuerbaustein mit dem Verzögerungsglied verbindet, ein Taktsignal übermittelt wird und dass das Taktsignal die Verzögerungszeit des Verzögerungsgliedes beeinflusst.

Zweckmäßige Weiterbildungen dieses Verfahrens sind Gegenstand der auf Anspruch 6 rückbezogenen Unteransprüche.

Die Erfindung geht von der Erkenntnis aus, dass ein Verzögerungsglied auch mit einem geeigneten digitalen Filter realisiert werden kann. Sowohl das digitale Filter als auch das RC-Glied sind jeweils ein Funktionsbaustein mit Verzögerungscharakteristik. Während beim RC-Glied die Verzögerungszeit nur durch eine Änderung der charakteristischen Kenndaten der Widerstands-/Kondensatorkombination, mithin einen Austausch dieser Bauteile, erreicht werden kann, kann beim digitalen Filter die Verzögerungszeit jederzeit, z. B. durch Modifikation interner Parameter, verändert werden.

Wenn gemäß Anspruch 2 bzw. Anspruch 7 das über die Taktleitung übermittelte Taktsignal auf einen Zähler des Verzögerungsgliedes wirkt und die Verzögerungszeit des Verzögerungsgliedes durch einen Ablauf des Zählers bestimmt ist, ist die Verzögerungszeit neben der Periodendauer des Taktsignals durch den Zähler selbst bestimmt. Damit ist eine besonders einfache Beeinflussung der Verzögerungszeit gegeben. Bei einem z. B. sieben Bit breiten Zähler, der entsprechend 64 Impulse zählen kann, kann die gewünschte Verzögerungszeit über eine Anpassung der Periodendauer des Taktsignals nach der Beziehung "Verzögerungszeit = 64 x Periodendauer" erfolgen.

Eine weitere Flexibilität bei der Vorgabe der Verzögerungszeit ergibt sich, wenn ein Start- oder Schwellwert des Zählers vorgegeben oder vorgebbar ist. Als Start- bzw. Schwellwert wird derjenige Wert bezeichnet, von dem ausgehend der Zähler abwärts bis Null zählt (Startwert) oder bis zu dem er ausgehend von Null aufwärts zählt (Schwellwert). Bei einem so genannten dekrementierenden Zähler, der vom Startwert zurück bis auf Null zählt, wird zur Beeinflussung der Verzögerungszeit der Startwert modifiziert. Bei einem so genannten inkrementierenden Zähler, der ausgehend von Null bis zum Schwellwert zählt, wird zur Beeinflussung der Verzögerungszeit der Schwellwert modifiziert. Je höher der Start- bzw. Schwellwert gewählt wird, desto länger ist die Verzögerungszeit. Die Beeinflussbarkeit des Start- oder Schwellwerts ist z. B. nützlich, wenn eine besonders kurze Verzögerungszeit vorgegeben werden soll, die nur mit einer oberen Grenzfrequenz des Taktsignals nicht erreicht werden kann.

Gemäß einer Ausgestaltung der Eingangsschaltung bzw. des Verfahrens zu deren Betrieb ist der Steuerbaustein mit dem Verzögerungsglied auch über eine Schreib- und Leseleitung sowie über einen Datenbus verbunden. Damit wird ermöglicht, dass der Steuerbaustein vor Ansteuerung eines der Mittel zur High- oder Lowpegelaufschaltung über die Leseleitung und den Datenbus die bereits abgelaufene Verzögerungszeit ausliest und nach Beendigung der Ansteuerung eines der Mittel zur High- oder Lowpegelaufschaltung über die Schreibleitung und den Datenbus die ausgelesene, abgelaufene Verzögerungszeit im Verzögerungsglied wieder herstellt.

Dies hat vorteilhaft den Effekt, dass nach dem Test der Eingangsschaltung durch die High- oder Lowpegelaufschaltung nicht erneut die komplette Verzögerungszeit verstreichen muss, bis auf eine Änderung des Prozesssignals reagiert werden kann.

Vorteilhaft liest der Steuerbaustein die bereits abgelaufene Verzögerungszeit direkt aus dem Zähler des Verzögerungsgliedes aus und stellt die ausgelesene, abgelaufene Verzögerungszeit direkt im Zähler des Verzögerungsgliedes wieder her. Dies vermeidet einerseits auf Seiten des Steuerbausteins z. B. einen eigenen Zähler zum Protokollieren der Anzahl der Impulse des Taktsignals und gewährleistet andererseits eine schnelle Wiederherstellung der abgelaufenen Verzögerungszeit, die ansonsten z. B. über eine kurzfristige Erhöhung der Taktfrequenz des Taktsignals erreicht werden könnte.

Bei der angegebenen Eingangsschaltung bzw. dem entsprechenden Betriebsverfahren ist in ungünstiger Weise beim Testen der Eingangsschaltung noch das definierte High- oder Low-Signal, im Folgenden als Testsignal bezeichnet, der durch das Verzögerungsglied vorgegebenen Verzögerungszeit unterworfen. Bei einer Verzögerungszeit von z. B. 3 ms muss z. B. das Testsignal für mindestens 3 ms am Signaleingang anstehen, damit es an den Steuerbaustein weitergeleitet wird. Während dieser Zeit kann nicht erkannt werden, welches Prozesssignal am Eingang der Eingangsschaltung anliegt. Das hat zur Folge, dass eine Reaktion auf eine Änderung des Prozesssignals erst nach Wegnahme des Testsignals und nach Verstreichen der ggf. restlichen Verzögerungszeit erfolgen kann. Wenn ein vollständiger Test der Eingangsschaltung mit High- und Lowpegelaufschaltung erfolgt und die Änderung des Prozesssignals zu Beginn des Tests erfolgt, kann während der dreifachen Verzögerungszeit keine Reaktion auf die Signaländerung erfolgen.

Daher ist weiter vorteilhaft vorgesehen, dass nach dem Auslesen der bereits abgelaufenen Verzögerungszeit eine vorgebbare oder vorgegebene minimale Verzögerungszeit eingestellt wird. Damit wird erreicht, dass der durch die High- oder Lowpegelaufschaltung an den Signaleingang gelegte Impuls nur einer minimalen Verzögerung unterworfen ist. Der Test der Eingangsschaltung kann damit erheblich beschleunigt werden. Der Zeitgewinn entspricht mindestens der Differenz zwischen der Verzögerungszeit des Verzögerungsgliedes im normalen Betrieb und der minimalen Verzögerungszeit während der High- oder Lowpegelaufschaltung.

Für den Test der Eingangsschaltung ist somit fast unmittelbar durch den Steuerbaustein ermittelbar, ob sich am Ausgang des Verzögerungsgliedes die durch die Aktivierung der High- oder Lowpegelaufschaltung beabsichtigten definierten Verhältnisse einstellen.

Das Einstellen der minimalen Verzögerungszeit wird vorteilhaft durch Verringerung der Periodendauer des über die Taktleitung übermittelten Taktsignals erreicht.

Zusätzlich oder alternativ kann das Einstellen der minimalen Verzögerungszeit durch geeignete Beeinflussung des Zählers, insbesondere durch Verringerung von dessen Start- oder Schwellwert, erreicht werden. Dazu werden nach Aktivierung der Schreibleitung der Zähler oder dessen Parameter über den Datenbus beeinflusst. Neben der Verringerung des Start- oder Schwellwertes kann auch vorgesehen sein, dass der aktuelle Stand des Zählers auf einen Wert knapp unterhalb des Start- oder Schwellwertes gesetzt wird, so dass sich die minimale Verzögerungszeit dadurch einstellt, dass der Start- oder Schwellwert bei den nachfolgenden Impulsen des Taktsignals erreicht wird und der Zähler damit abläuft.

Nachfolgend wird ein Ausführungsbeispiel der Erfindung anhand der Zeichnung näher erläutert. Einander entsprechende Gegenstände oder Elemente sind in allen Figuren mit den gleichen Bezugszeichen versehen.

Darin zeigen
- FIG 1: ein Prinzipschaltbild einer bekannten testbaren Eingangsschaltung und
- FIG 2: ein Prinzipschaltbild eines Ausführungsbeispiels einer Eingangsschaltung gemäß der Erfindung.

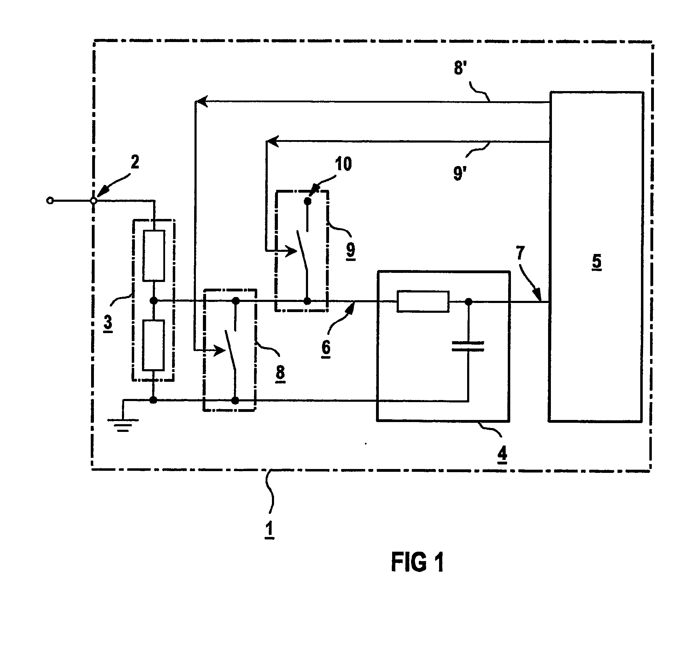

FIG 1 zeigt ein Prinzipschaltbild einer bekannten testbaren Eingangsschaltung 1 mit einem Eingang 2, an den ein Eingangssignal angelegt werden kann. Das am Eingang 2 anliegende Eingangssignal wird zur Unterscheidung als Prozesssignal bezeichnet. Es wird z. B. von einem nicht dargestellten Endschalter oder Bedienelement eines gleichfalls nicht dargestellten technischen Prozesses geliefert.

Die Eingangsschaltung 1 umfasst einen Spannungsteiler 3 mit einem Mittelabgriff, ein Verzögerungsglied 4 in Form eines RC-Gliedes 4 und einen Steuerbaustein 5. Für praktische Anwendungen ist die Eingangsschaltung mehrfach ausgeführt, so dass durch den Steuerbaustein 5 z. B. acht, sechzehn, etc. Eingänge überwacht und ausgewertet werden können.

Der Eingang 2 bildet einen der beiden Pole des Spannungsteilers 3. Der andere Pol des Spannungsteilers 3 liegt an Masse. Einer der beiden Eingänge des RC-Gliedes 4 liegt gleichfalls an Masse. Der andere Eingang 6 des RC-Gliedes 4, zur Unterscheidung als Signaleingang 6 bezeichnet, liegt am Mittelabgriff des Spannungsteilers 3. Das RC-Glied 4 weist einen Ausgang 7 auf. Dieser wird dem Steuerbaustein 5 zugeführt. Das RC-Glied 4 bewirkt je nach Dimensionierung der enthaltenen Widerstands-/Kondensatorkombination eine Verzögerung der Auswirkung von Impulsen am Signaleingang 6 auf den Ausgang 7. Nur Impulse, die während einer kompletten, durch das RC-Glied 4 bewirkten Verzögerungszeit am Signaleingang 6 anstehen, gelangen zum Ausgang 7 und damit zum Steuerbaustein 5. Durch die Dimensionierung des RC-Gliedes 4 ist die Verzögerungszeit festgelegt. Zum Betrieb der Eingangsschaltung 1 mit einer anderen Verzögerungszeit muss das als Verzögerungsglied 4 fungierende RC-Glied 4 ausgetauscht oder dessen Widerstands-/Kondensatorkombination verändert werden.

Zum Testen der Eingangsschaltung 1 sind ein erster und ein zweiter elektrisch betätigbarer Schalter 8, 9 vorgesehen. Der erste elektrisch betätigbare Schalter 8, die Lowpegelaufschaltung 8, liegt mit einem Pol an Masse und mit dem anderen Pol am Signaleingang 6 des RC-Gliedes 4. Er ist mittels einer ersten Steuerleitung 8' des Steuerbausteins 5 ansteuerbar. Der zweite elektrisch betätigbare Schalter 9, die Highpegelaufschaltung 9, liegt mit einem Pol an einem Bezugspotential 10 und mit dem anderen Pol am Signaleingang 6 des RC-Gliedes 4. Er ist mittels einer zweiten Steuerleitung 9' des Steuerbausteins 5 ansteuerbar.

Zum Testen der Eingangsschaltung 1 steuert der Steuerbaustein 5 in einer vorgegebenen oder vorgebbaren Abfolge über jeweils eine der Steuerleitungen 8', 9' einen der elektrisch betätigbaren Schalter 8, 9 an. Bei Ansteuerung der Lowpegelaufschaltung 8 wird der Schalter 8 geschlossen und der Signaleingang 6 damit auf Massepotential gelegt. Bei Ansteuerung der Highpegelaufschaltung 9 wird der Schalter 9 geschlossen und der Signaleingang 6 damit auf das Bezugspotential 10 gelegt. Auf diese Weise können durch den Steuerbaustein 5 definierte Verhältnisse am Signaleingang 6 vorgegeben werden. Der Signaleingang 6 wird über das RC-Glied 4 und den Ausgang 7 an den Steuerbaustein 5 weitergeleitet. Durch den Steuerbaustein 5 ist damit überprüfbar, ob ein Eingangssignal gelesen wird, das den durch die High- oder Lowpegelaufschaltung vorgegebenen definierten Verhältnissen entspricht. Ist dies der Fall, gilt die Eingangsschaltung 1 als funktionstüchtig. Ist dies nicht der Fall, gilt die Eingangsschaltung 1 als fehlerhaft. Der Steuerbaustein 5 kann dann mit einem entsprechenden Signal (nicht dargestellt) die Fehlerhaftigkeit der Eingangsschaltung 1 anzeigen.

Die Eingangsschaltung 1 hat drei unterscheidbare Betriebszustände, nämlich Normalbetrieb, Hightest und Lowtest. High- und Lowtest werden zusammenfassend als Testmodus bezeichnet.

Im Normalbetrieb ist der Schalter 8 der Lowpegelaufschaltung 8 und der Schalter 9 der Highpegelaufschaltung 9 geöffnet. Das Prozesssignal am Eingang 2 wirkt über den Spannungsteiler 3 und den Signaleingang 6 auf das RC-Glied 4. Nach Ablauf der durch das RC-Glied 4 vorgegebenen Verzögerungszeit von z. B. 3 ms gelangt das Prozesssignal an den Ausgang 7 und somit zum Steuerbaustein 5.

Bei der Beschreibung des Testmodus, exemplarisch am Beispiel des Hightests durchgeführt, werden ergänzend die Zeiten betrachtet, die bei einer Verzögerungszeit des RC-Gliedes 4 von z. B. 3 ms verstreichen, bis auf eine Änderung des Prozesssignals reagiert werden kann:
t = 0,0 ms: Das Prozesssignal am Eingang 2 wechselt.
t = 2,9 ms: Durch den Steuerbaustein 5 wird der Hightest der Eingangsschaltung 1 gestartet. Über die Steuerleitung 9' wird der Schalter 9 der Highpegelaufschaltung 9 geschlossen. Das Bezugspotential 10 wirkt auf den Signaleingang 6.
t = 5,9 ms: Nach Ablauf der vorgegebenen Verzögerungszeit von 3 ms erkennt der Funktionsbaustein 5 bei funktionstüchtiger Eingangsschaltung 1 am Ausgang 7 des RC-Gliedes 4 das erwartete Signal.
t = 6,0 ms: Der Funktionsbaustein 5 beendet den Hightest. Die Highpegelaufschaltung 9 wird durch Öffnen des Schalters 9 inaktiv geschaltet. Auf den Signaleingang 6 wirkt wieder das Prozesssignal.
t = 9,0 ms: Nach erneutem Ablauf der vorgegebenen Verzögerungszeit von 3 ms erkennt der Funktionsbaustein 5 den Status des Prozesssignals.

Die zeitlichen Verhältnisse während des Lowtests entsprechen denen während des Hightests.

Damit kann festgestellt werden, dass die Zeit zur Reaktion auf eine Änderung des Prozesssignals durch den Test der Eingangsschaltung 1 zumindest um die Dauer der Verzögerungszeit während des Hightests verlängert wird. Des Weiteren verlängert sich die Zeit zur Reaktion auf eine Änderung des Prozesssignals durch den Ablauf der Verzögerungszeit vor und nach dem Hightest. Im ungünstigsten Fall addieren sich die Zeiten derart, dass während der dreifachen Verzögerungszeit keine Reaktion auf eine Änderung des Prozesssignals möglich ist; durch den Test wurde die Eingangsverzögerung für das Prozesssignal um 6 ms erhöht.

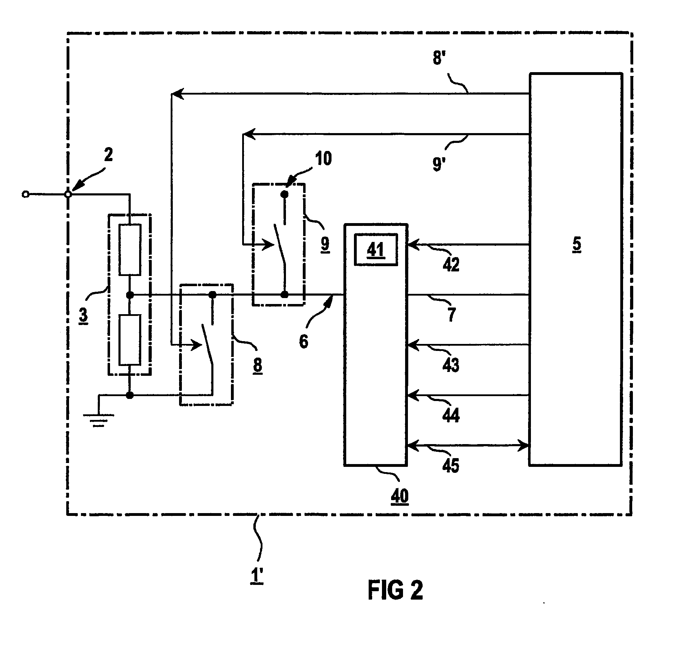

FIG 2 zeigt ein Prinzipschaltbild eines Ausführungsbeispiels einer Eingangsschaltung 1' gemäß der Erfindung. Die Eingangsschaltung 1' unterscheidet sich von der bekannten Eingangsschaltung 1, wie sie in FIG 1 dargestellt ist, dadurch, dass als Verzögerungsglied 40 anstelle des RC-Gliedes 4 (FIG 1) ein Funktionsbaustein 40 mit einem Zähler 41 vorgesehen ist. Die Funktionalität der Eingangsschaltung 1' entspricht der Funktionalität der in FIG 1 dargestellten Eingangsschaltung 1.

Der Funktionsbaustein 40 ist insbesondere ein hochintegrierter programmierbarer Logikbaustein 40 mit Verzögerungscharakteristik. Dem Funktionsbaustein 40 wird wie dem RC-Glied 4 (FIG 1) bei nicht angesteuerter High- und Lowpegelaufschaltung 8, 9 an dessen Signaleingang 6 das Prozesssignal zugeführt. Dieses Signal wird nach Ablauf der Verzögerungszeit des Funktionsbausteins 40 über den Ausgang 7 an den Steuerbaustein 5 weitergeleitet.

Zur Steuerung und Überwachung des Funktionsbausteins 40 durch den Steuerbaustein 5 ist eine Taktleitung 42, eine Schreib- und eine Leseleitung 43, 44 sowie ein Datenbus 45 vorgesehen.

Mit dem Funktionsbaustein 40 wird ein digitales Verzögerungsglied 40 realisiert. Dessen Verzögerungszeit wird durch die Periodendauer eines über die Taktleitung 42 übermittelten, auf den Zähler 41 wirkenden Taktsignals sowie einen vorgegebenen oder vorgebbaren Start- oder Schwellwert, im Folgenden zusammengefasst als "Faktor" bezeichnet, bestimmt. Damit wird die Verzögerungszeit nach der Formel "Verzögerungszeit = Faktor × Periodendauer des Taktsignals" bestimmt, wobei "Faktor" insbesondere für eine natürliche Zahl, z. B. "64", steht. Mit dem Zähler 41 wird die integrierende Funktion eines RC-Gliedes nachgebildet. Der Stand des Zählers 41 ist ein Maß für die schon abgelaufene Zeit.

Das am Signaleingang 6 anliegende Signal wird nach Ablauf der Verzögerungszeit über den Ausgang 7 an den Steuerbaustein 5 geleitet. Impulse am Signaleingang 6, die kürzer sind als die eingestellte Verzögerungszeit, werden unterdrückt und gelangen entsprechend nicht zum Ausgang 7 und damit auch nicht zum Steuerbaustein 5.

Der Stand des Zählers 41 kann durch Aktivierung der Leseleitung 44 am Datenbus 45 gelesen werden. Durch Aktivierung der Schreibleitung 43 kann der Stand des Zählers 41 über den Datenbus 45 durch den Steuerbaustein 5 definiert verändert werden.

Auch die Eingangsschaltung 1' hat die drei unterscheidbaren Betriebszustände Normalbetrieb, Hightest und Lowtest.

Im Normalbetrieb ist der Schalter 8 der Lowpegelaufschaltung 8 und der Schalter 9 der Highpegelaufschaltung 9 geöffnet. Das Prozesssignal am Eingang 2 wirkt über den Spannungsteiler 3 und den Signaleingang 6 auf das Verzögerungsglied 40. Nach Ablauf der durch das Verzögerungsglied 40 vorgegebenen Verzögerungszeit von z. B. 3 ms gelangt das Prozesssignal an den Ausgang 7 und somit zum Steuerbaustein 5.

Bei der Beschreibung des Testmodus, exemplarisch wieder am Beispiel des Hightests durchgeführt, werden ergänzend die Zeiten betrachtet, die bei einer Verzögerungszeit des Verzögerungsgliedes 40 von z. B. 3 ms verstreichen, bis auf eine Änderung des Prozesssignals reagiert werden kann:
t = 0,0 ms: Das Prozesssignal am Eingang 2 wechselt.
t = 2,9 ms: Der Funktionsbaustein 5 startet den Hightest der Eingangsschaltung 1'.
   Dazu wird durch den Steuerbaustein 5 der Stand des Zählers 41 ausgelesen und gespeichert. Der Stand des inkrementierenden Zählers 41 wird auf den Wert "0" gesetzt.
   Ferner wird über die Steuerleitung 9' der Schalter 9 der Highpegelaufschaltung 9 geschlossen. Das Bezugspotential 10 wirkt auf den Signaleingang 6.
   Der Steuerbaustein 5 gibt an der Taktleitung 42 ein Taktsignal mit maximaler Ausgangsfrequenz vor.
t = 2,9 ms + δt: Bei Erreichen des Schwellwertes des inkrementierenden Zählers 41 muss bei funktionstüchtiger Eingangsschaltung 1' am Ausgang 7 der aufgeschaltete High-Pegel anstehen.
   Der Funktionsbaustein 5 beendet den Hightest. Die Highpegelaufschaltung 9 wird durch Öffnen des Schalters 9 inaktiv geschaltet. Auf den Signaleingang 6 wirkt wieder das Prozesssignal. Abschließend stellt der Steuerbaustein 5 den anfangs gelesenen Stand des Zählers 41 wieder her.
t ≈ 3,0 ms: Auf den Eingang 2 wirkt das Prozesssignal.
t ≈ 3,1 ms: Nach Ablauf der gesamten vorgegebenen Verzögerungszeit von 3 ms (2,9 ms vor dem Hightest und 0,1 ms nach dem Hightest) erkennt der Funktionsbaustein 5 den Status des Prozesssignals.

Die zeitlichen Verhältnisse während des Lowtests entsprechen wieder denen während des Hightests.

Die Zeit zur Reaktion auf einen Wechsel des Prozesssignals beträgt danach im ungünstigsten Fall, d. h. wenn der Test unmittelbar vor Ablauf der Verzögerungszeit im Normalbetrieb gestartet wird, ca. 3,1 ms. Durch den Test wurde die Eingangsverzögerung nur um ca. 0,1 ms erhöht.

Im Vergleich mit der Eingangsschaltung gemäß FIG 1 ergibt sich damit eine erheblich verbesserte Reaktionszeit auf Änderungen des Prozesssignals. Dies ist darauf zurückzuführen, dass die Verzögerungszeit, die bereits vor Beginn des Testmodus verstrichen ist, nicht "verloren geht", sondern durch Auslesen des Zählerstandes gespeichert wird, und dass während des Testmodus nur eine minimale Verzögerungszeit wirkt, die sich durch Beeinflussung des Taktsignals ergibt.

Damit lassen sich die Erfindung sowie vorteilhafte Ausgestaltungen derselben kurz wie folgt darstellen:

Es wird eine durch gesteuerte Aufschaltung eines High- oder Low-Pegels testbare Eingangsschaltung 1' mit einem Verzögerungsglied 40 sowie ein Verfahren zu deren Betrieb angegeben, bei der/bei dem die Verzögerungszeit des Verzögerungsgliedes 40 während des Betriebs der Eingangsschaltung 1' veränderbar ist. Gemäß einer Ausgestaltung wird die verstrichene Verzögerungszeit vor dem Test der Eingangsschaltung 1' ausgelesen und nach dem Test wieder hergestellt, so dass sich keine Erhöhung der für Prozesssignale wirksamen Eingangsverzögerung durch den Test ergibt. Zusätzlich oder alternativ wird des Weiteren vor dem Test die Verzögerungszeit auf einen Minimalwert gesetzt, so dass ein schneller Test der Eingangsschaltung 1' unabhängig von der eingestellten Verzögerungszeit möglich wird.

## Patentansprüche

1. Eingangsschaltung (1, 1') mit einem Eingang (2), einem Spannungsteiler (3) mit einem Mittelabgriff, einem Verzögerungsglied (4, 40), einem Steuerbaustein (5) und Mitteln (8, 8'; 9, 9') zur High- und Lowpegelaufschaltung,
- wobei ein erster Pol (2) des Spannungsteilers (3) den Eingang (2) der Eingangsschaltung (1, 1') bildet,
- wobei ein Signaleingang (6) des Verzögerungsglieds (4, 40) am Mittelabgriff des Spannungsteilers (3) liegt und ein Ausgang (7) des Verzögerungsglieds (4, 40) mit dem Steuerbaustein (5) verbunden ist und
- wobei die Mittel (8, 8'; 9, 9') zur High- und Lowpegelaufschaltung durch den Steuerbaustein (5) steuerbar und geeignet sind, auf den Signaleingang (6) zu wirken,
**dadurch gekennzeichnet,**
**dass** der Steuerbaustein (5) mit dem Verzögerungsglied (40) über eine Taktleitung (42) verbunden ist und
**dass** eine Verzögerungszeit des Verzögerungsgliedes (40) mittels eines über die Taktleitung (42) übermittelbaren Taktsignals beeinflussbar ist.

2. Eingangsschaltung nach Anspruch 1,
wobei das über die Taktleitung (42) übermittelte Taktsignal auf einen Zähler (41) des Verzögerungsgliedes (40) wirkt und die Verzögerungszeit des Verzögerungsgliedes (40) durch einen Ablauf des Zählers (41) bestimmt ist.

3. Eingangsschaltung nach Anspruch 2,
wobei ein Start- oder Schwellwert des Zählers (41) vorgegeben oder vorgebbar ist.

4. Eingangsschaltung nach Anspruch 1, 2 oder 3,
wobei der Steuerbaustein (5) mit dem Verzögerungsglied (40) ferner über eine Schreib- und Leseleitung (43, 44) sowie über einen Datenbus (45) verbunden ist,
wobei der Steuerbaustein (5) vor Ansteuerung eines der Mittel (8, 8'; 9, 9') zur High- oder Lowpegelaufschaltung über die Leseleitung (43) und den Datenbus (45) die bereits abgelaufene Verzögerungszeit aus Verzögerungsglied (40) ausliest und nach Beendigung der Ansteuerung eines der Mittel (8, 8'; 9, 9') zur High- oder Lowpegelaufschaltung über die Schreibleitung (44) und den Datenbus (45) die ausgelesene, abgelaufene Verzögerungszeit im Verzögerungsglied (40) wieder herstellt.

5. Eingangsschaltung nach Anspruch 2 oder 3 und Anspruch 4,
wobei der Steuerbaustein (5) die bereits abgelaufene Verzögerungszeit aus dem Zähler (41) des Verzögerungsgliedes (40) ausliest und die ausgelesene, abgelaufene Verzögerungszeit im Zähler (41) des Verzögerungsgliedes (40) wieder herstellt.

6. Verfahren zum Betrieb einer Eingangsschaltung (1, 1') mit einem Eingang (2), einem Spannungsteiler (3) mit einem Mittelabgriff, einem Verzögerungsglied (4, 40), einem Steuerbaustein (5) und Mitteln (8, 8'; 9, 9') zur High- und Lowpegelaufschaltung,
- wobei ein erster Pol (2) des Spannungsteilers (3) den Eingang (2) der Eingangsschaltung (1, 1') bildet,
- wobei ein Signaleingang (6) des Verzögerungsglieds (4, 40) am Mittelabgriff des Spannungsteilers (3) liegt und ein Ausgang (7) des Verzögerungsglieds (4, 40) mit dem Steuerbaustein (5) verbunden ist und
- wobei die Mittel (8, 8'; 9, 9') zur High- und Lowpegelaufschaltung durch den Steuerbaustein (5) gesteuert werden und auf den Signaleingang (6) wirken,
**dadurch gekennzeichnet,**
**dass** über eine Taktleitung (42), die den Steuerbaustein (5) mit dem Verzögerungsglied (40) verbindet, ein Taktsignal übermittelt wird und dass das Taktsignal eine Verzögerungszeit des Verzögerungsgliedes (40) beeinflusst.

7. Betriebsverfahren nach Anspruch 6,
wobei das über die Taktleitung (42) übermittelte Taktsignal auf einen Zähler (41) des Verzögerungsgliedes (40) wirkt und die Verzögerungszeit des Verzögerungsgliedes (40) durch einen Ablauf des Zählers (41) bestimmt ist.

8. Betriebsverfahren nach Anspruch 7,
wobei ein Start- oder Schwellwert des Zählers (41) vorgegeben ist oder vorgegeben wird.

9. Betriebsverfahren nach Anspruch 6, 7 oder 8,
wobei der Steuerbaustein (5) mit dem Verzögerungsglied (40) ferner über eine Schreib- und Leseleitung (43, 44) sowie über einen Datenbus (45) verbunden ist,
wobei vor Ansteuerung eines der Mittel (8, 8'; 9, 9') zur High- oder Lowpegelaufschaltung über die Leseleitung (43) und den Datenbus (45) durch den Steuerbaustein (5)
- die bereits abgelaufene Verzögerungszeit ausgelesen wird und
nach Beendigung der Ansteuerung eines der Mittel (8, 8'; 9, 9') zur High- oder Lowpegelaufschaltung über die Schreibleitung (44) und den Datenbus (45)
- die ausgelesene, abgelaufene Verzögerungszeit im Verzögerungsglied (40) wieder hergestellt wird.

10. Betriebsverfahren nach Anspruch 7 oder 8 und Anspruch 9,
wobei durch den Steuerbaustein (5) die bereits abgelaufene Verzögerungszeit aus dem Zähler (41) des Verzögerungsgliedes (40) ausgelesen und die ausgelesene, abgelaufene Verzögerungszeit im Zähler (41) des Verzögerungsgliedes (40) wieder hergestellt wird.

11. Betriebsverfahren nach Anspruch 9 oder 10,
wobei nach Auslesen der bereits abgelaufenen Verzögerungszeit eine vorgebbare oder vorgegebene minimale Verzögerungszeit eingestellt wird.

12. Betriebsverfahren nach Anspruch 11,
wobei das Einstellen der minimalen Verzögerungszeit durch Verringerung der Periodendauer des über die Taktleitung (42) übermittelten Taktsignals erreicht wird.

13. Betriebsverfahren nach Anspruch 11,
wobei das Einstellen der minimalen Verzögerungszeit durch Verringerung des Start- oder Schwellwerts des Zählers (41) erreicht wird.

14. Betriebsverfahren nach Anspruch 11,
wobei das Einstellen der minimalen Verzögerungszeit durch Beeinflussung des aktuellen Zählerstandes erreicht wird.

## Claims

1. Input circuit (1, 1') having an input (2), a potential divider (3) having a centre tap, a delay element (4, 40), a control device (5) and means (8, 8'; 9, 9') for high-level and low-level connection,
- where a first pole (2) of the potential divider (3) forms the input (2) of the input circuit (1, 1'),
- where a signal input (6) of the delay element (4, 40) is taken to the centre tap of the potential divider (3), and an output (7) of the delay element (4, 40) is connected to the control device (5), and
- where the means (8, 8'; 9, 9') for high-level and low-level connection can be controlled by the control device (5), and are suitable to act on the signal input (6),
**characterized in that**
the control device (5) is connected to the delay element (40) via a clock line (42), and that a delay time of the delay element (40) can be controlled by means of a clock signal that can be transferred via the clock line (42).

2. Input circuit according to Claim 1,
where the clock signal transferred via the clock line (42) acts on a counter (41) of the delay element (40), and the delay time of the delay element (40) is set by one count-through of the counter (41).

3. Input circuit according to Claim 2,
where a start value or threshold value of the counter (41) is specified or can be specified.

4. Input circuit according to Claim 1, 2 or 3,
where the control device (5) is also connected to the delay element (40) via a read line and write line (43, 44) and via a data bus (45),
where the control device (5), before activating one of the means (8, 8'; 9, 9') for high-level or low-level connection, reads from the delay element (40), via the read line (43) and the data bus (45), the delay time already elapsed, and at the end of activating one of the means (8, 8'; 9, 9') for high-level or low-level connection, re-sets in the delay element (40), via the write line (44) and the data bus (45), the elapsed delay time that was read.

5. Input circuit according to Claim 2 or 3 and Claim 4,
where the control device (5) reads the delay time already elapsed from the counter (41) of the delay element (40), and re-sets the elapsed delay time that was read in the counter (41) of the delay element (40).

6. Method for operating an input circuit (1, 1') having an input (2), a potential divider (3) having a centre tap, a delay element (4, 40), a control device (5) and means (8, 8'; 9, 9') for high-level and low-level connection,
- where a first pole (2) of the potential divider (3) forms the input (2) of the input circuit (1, 1'),
- where a signal input (6) of the delay element (4, 40) is taken to the centre tap of the potential divider (3), and an output (7) of the delay element (4, 40) is connected to the control device (5), and
- where the means (8, 8'; 9, 9') for high-level and low-level connection are controlled by the control device (5) and act on the signal input (6),
**characterized in that**
a clock signal is transferred via a clock line (42) which connects the control device (5) to the delay element (40), and that the clock signal controls a delay time of the delay element (40).

7. Operating method according to Claim 6,
where the clock signal transferred via the clock line (42) acts on a counter (41) of the delay element (40), and the delay time of the delay element (40) is set by one count-through of the counter (41).

8. Operating method according to Claim 7,
where a start value or threshold value of the counter (41) is specified or is being specified.

9. Operating method according to Claim 6, 7 or 8,
where the control device (5) is also connected to the delay element (40) via a read line and write line (43, 44) and via a data bus (45),
where before activating one of the means (8, 8'; 9, 9') for high-level or low-level connection
- the delay time already elapsed is read by the control device (5) via the read line (43) and the data bus (45),
and at the end of activating one of the means (8, 8'; 9, 9') for high-level or low-level connection
- the elapsed delay time that was read is re-set in the delay element (40)
via the write line (44) and the data bus (45).

10. Operating method according to Claim 7 or 8 and Claim 9,
where the control device (5) reads the delay time already elapsed from the counter (41) of the delay element (40), and re-sets the elapsed delay time that was read in the counter (41) of the delay element (40).

11. Operating method according to Claim 9 or 10,
where after reading the delay time that has already elapsed, a specifiable or specified minimum delay time is set.

12. Operating method according to Claim 11,
where the minimum delay time is set by reducing the period of the clock signal transferred via the clock line (42).

13. Operating method according to Claim 11,
where the minimum delay time is set by reducing the start value or threshold value of the counter (41).

14. Operating method according to Claim 11,
where the minimum delay time is set by controlling the current counter count.

## Revendications

1. Circuit (1, 1') d'entrée ayant une entrée (2), un diviseur (3) de tension à prise médiane, un élément (4, 40) à retard, un module (5) de commande et des moyens (8, 8', 9, 9') de mise au niveau haut et au niveau bas,
- dans lequel un premier pôle (2) du diviseur (3) de tension forme l'entrée (2) du circuit (1, 1') d'entrée ;
- dans lequel une entrée (6) de signal de l'élément (4, 40) à retard s'applique à la prise médiane du diviseur (3) de tension et une sortie (7) de l'élément (4, 40) à retard est reliée au module (5) de commande ; et
- dans lequel les moyens (8, 8', 9, 9') de mise au niveau haut et au niveau bas peuvent être commandés par le module (5) de commande et sont propres à agir sur l'entrée (6) de signal,
**caractérisé**
**en ce que** le module (5) de commande est relié à l'élément (40) à retard par une ligne (42) d'horloge, et
**en ce qu'**une durée de retard de l'élément (40) à retard peut être influencée au moyen d'un signal d'horloge qui peut être transmis par la ligne (42) d'horloge.

2. Circuit d'entrée suivant la revendication 1,
dans lequel le signal d'horloge transmis par la ligne (42) d'horloge agit sur un compteur (41) de l'élément (40) à retard et détermine la durée de retard de l'élément (40) à retard par un fonctionnement du compteur (41).

3. Circuit d'entrée suivant la revendication 2,
dans lequel une valeur de lancement ou de seuil du compteur (41) est prescrite ou peut l'être.

4. Circuit d'entrée suivant la revendication 1, 2 ou 3,
dans lequel le module (5) de commande est relié à l'élément (40) à retard, en outre, par une ligne (43, 44) d'écriture et de lecture ainsi que par un bus (45) de données ;
le module (5) de commande lisant, avant la commande de l'un des moyens (8, 8', 9, 9') de mise au niveau haut ou au niveau bas par la ligne (43) de lecture et par le bus (45) de données, la durée de retard déjà écoulée dans l'élément (40) à retard et reproduisant dans l'élément (40) à retard, après la fin de la commande de l'un des moyens (8, 8', 9, 9') de mise au niveau haut ou au niveau bas par la ligne (44) d'écriture et par le bus (45) de données, la durée de retard lue et écoulée.

5. Circuit d'entrée suivant la revendication 2 ou 3 et 4,
dans lequel le module (5) de commande lit dans le compteur (41) de l'élément (40) à retard la durée de retard déjà expirée et reproduit dans le compteur (41) de l'élément (40) à retard la durée de retard lue et écoulée.

6. Procédé pour faire fonctionner un circuit (1, 1') d'entrée ayant une entrée (2), un diviseur (3) de tension à prise médiane, un élément (4, 40) à retard, un module (5) de commande et des moyens (8, 8', 9, 9') de mise au niveau haut et au niveau bas,
- dans lequel un premier pôle (2) du diviseur (3) de tension forme l'entrée (2) du circuit (1, 1') d'entrée ;
- dans lequel une sortie (6) de signal de l'élément (4, 40) à retard s'applique à la prise médiane du diviseur (3) de tension et une sortie (7) de l'élément (4, 40) à retard est reliée au module (5) de commande ; et
- dans lequel les moyens (8, 8', 9, 9') de mise au niveau haut et au niveau bas peuvent être commandés par le module (5) de commande et sont propres à agir sur l'entrée (6) de signal,
**caractérisé**
**en ce que** l'on transmet par une ligne (42) d'horloge qui relie le module (5) de commande à l'élément (40) à retard un signal d'horloge et en ce que l'on influe par le signal d'horloge une durée de retard de l'élément (40) à retard.

7. Procédé suivant la revendication 6,
dans lequel on agit par le signal d'horloge transmis par la ligne (42) d'horloge sur un compteur (41) de l'élément (40) à retard et l'on détermine la durée de retard de l'élément (40) à retard par un fonctionnement du compteur (41).

8. Procédé suivant la revendication 7,
dans lequel on prescrit une valeur de lancement ou de seuil du compteur (41).

9. Procédé suivant les revendications 6, 7 et 8,
dans lequel le module (5) de commande est relié à l'élément (40) à retard, en outre, par une ligne (43, 44) d'écriture et de lecture ainsi que par un bus (45) de données ;
dans lequel, avant la commande de l'un des moyens (8, 8', 9, 9') pour le circuit de mise au niveau haut ou au niveau bas, on lit en passant par la ligne (43) de lecture et par le bus (45) de données par le module (5) de commande
- la durée de retard déjà écoulée ; et
après la fin de la commande de l'un des moyens (8, 8', 9, 9') de mise au niveau haut ou au niveau bas, on reproduit en passant par la ligne (44) d'écriture et par le bus (45) de données
- dans l'élément (40) à retard la durée de retard lue et écoulée.

10. Procédé suivant la revendication 7 ou 8 et la revendication 9,
dans lequel on lit par le module (5) de commande la durée de retard déjà écoulée dans le compteur (41) de l'élément (40) à retard et l'on reproduit dans le compteur (41) de l'élément (40) à retard la durée de retard lue et écoulée.

11. Procédé suivant la revendication 9 ou 10,
dans lequel, après avoir lu la durée de retard déjà écoulée, on règle une durée de retard minimum prescrite ou qui peut l'être.

12. Procédé suivant la revendication 11,
dans lequel on obtient le réglage de la durée de retard minimum en diminuant la durée de période du signal d'horloge transmis par la ligne (42) d'horloge.

13. Procédé suivant la revendication 11,
dans lequel on obtient le réglage de la durée de retard minimum en diminuant la valeur de lancement ou la valeur de seuil du compteur (41).

14. Procédé suivant la revendication 11,
dans lequel on obtient le réglage de la durée de retard minimum en influant sur l'état actuel du compteur.
